# EUROPÄISCHE PATENTSCHRIFT

(11) **EP 0 621 483 B1**
(45) Veröffentlichungstag und Bekanntmachung des Hinweises auf die Patenterteilung: **15.03.2000**
(21) Anmeldenummer: 94100760.1
(22) Anmeldetag: 20.01.1994
(51) Int. Cl.: G01R 1/04, H01R 9/26

(54) **Prüfstecker für Reihenklemmen**
Test connector for series terminal
Connecteur de test pour borne de raccordement

(30) Priorität: 19.04.1993 DE 4312667
(43) Veröffentlichungstag der Anmeldung: 26.10.1994
(73) Patentinhaber: Weidmüller Interface GmbH & Co., D-32760 Detmold (DE)
(72) Erfinder: Möller, Ulrich, D-32760 Detmold (DE); Murray, Meter, D-32760 Detmold (DE); Schulze, Rainer, D-32760 Detmold (DE); Strate, Klaus, D-32758 Detmold (DE); Wilmes, Manfred, D-32760 Detmold (DE)
(74) Vertreter: Loesenbeck, Karl-Otto, Dipl.-Ing.

(56) Entgegenhaltungen:
- WO-A-89/05532
- DE-A- 2 219 131
- GB-A- 2 112 221
- GB-A- 2 216 347

## Beschreibung

Die Erfindung betrifft einen Prüfstecker für Reihenklemmen gemäß dem Gattungsbegriff des Anspruches 1. Bei den bekannten Prüfsteckern (DE 81 34 454 U1) sind die zur mechanischen Verbindung mit dem Reihenklemmengehäuse vorgesehenen, an ihrem unteren Ende einen Rasthaken aufweisen Beine als an das Steckergehäuse angeformte Federbeine ausgebildet. Dies führt systembedingt zu einer gewissen federnden Beweglichkeit und Labilität, so daR Zug, Stoß oder sonstige mechanische Belastungen am Gehäuse des aufgesetzten Prüfsteckers oder am externen, in das Prüfsteckergehäuse führenden und dort mit der Prüfkontaktspitze elektrisch leitend verbundenen Leiter zur Beeinträchtigung und auch zum Verlust des Kontaktes der Spitze des Prüfkontaktstiftes mit dem entsprechenden kontaktierten Element in der Reihenklemme während der Prüfphase führen.

Diese Gefahr besteht selbst dann, wenn, wie gemäß bekanntem Stand der Technik vorgeshen, zwei derartige Rastfederbeine vorgesehen sind, was andererseits den Nachteil hat, daß in der Prüfphase aufgrund der Größe des Prüfsteckers zu dessen Aufsetzen der Querverbindungskanal der Reihenklemme genommen werden muß, der dann in der Prüfphase blockiert ist.

Der vorliegenden Erfindung liegt die Aufgabe zugrunde, einen Prüfstecker der gattungsgemäßen Art zu schaffen, der in der Prüfphase auch bei äußeren mechanischen Belastungen eine sichere elektrische Kontaktierung der Prüfkontaktspitze gewährleistet.

Die erfindungsgemäße Lösung gemäß Patentanspruch 1 besteht darin, daß das Bein ein drehbar am Steckergehäuse gelagerter Betätigungshebel ist, der in Verhakungsdrehrichtung unter Federkraft gesetzt ist. Ein solcher Betätigungshebel kann in sich im wesentlichen starr ausgebildet sein. Die Federkraft kann entsprechend hoch bemessen werden, so daß insgesamt eine steife starre Formschlußverbindung zwischen dem Prüfsteckergehäuse und dem Reihenklemmengehäuse zu erreichen ist. Über eine entsprechende Hebelarmauslegung bleibt die Formschlußverbindung leicht lösbar. Die Anordnung ist auch bedienungsbequem, da dank dieser Ausgestaltung der Betätigungshebel beim Einstecken des Prüfsteckers nicht gesondert betätigt werden muß. Unter Zugrundelegung einer angepaßten und entsprechenden Konturierung der Ausnehmung im Klemmengehäuse wird beim Einstecken der Betätigungshebel gegen die Federkraft gedreht. Sein Rasthaken schnappt in entsprechender Einsteckstellung unter die entsprechende Gehäusekontur und wird hier von der Federkraft gehalten. Die Lage der Federkraft in Verhakungsdrehrichtung bewirkt auch, daß ihre Richtungslage im wesentlichen quer zur kritischen mechanischen Belastungsrichtung (Abzug nach oben) liegt und daher von diesen kritischen mechanischen Kräften im wesentlichen unberührt bleibt.

Gemäß einer weiteren besonders zweckmäßigen, in Anspruch 2 gekennzeichneten Ausgestaltung ist vorgesehen, daß an der Prüfkontaktspitze ein flexibler Leiter befestigt ist, der im Steckergehäuse zu einem ortsfest angebrachten Leiteranschluß zum Anschließen eines externen Leiters geführt ist. Diese Ausgestaltung bewirkt, daß auch ein etwaiger Zug am externen Leiter ohne jeden schädigenden Einfluß auf die elektrische Kontaktierung der Spitze des Prüfkontaktstiftes bleibt. Ein solcher Zug wird vom Leiteranschluß auf das Steckergehäuse geleitet und von diesem, wie vorstehend geschildert, aufgenommen. Leiteranschluß und Prüfanschluß sind somit mechanisch getrennt. Die Flexibilität des im Prüfsteckergehäuse befindlichen, an die Prüfkontaktspitze angeschlossenen Leiters ermöglicht den Beibehalt der elektrischen Verbindung auch bei den Verschiebebewegungen der Prüfkontaktspitze im Prüfsteckergehäuse.

Weitere besondere Ausgestaltungen sind in weiteren Unteransprüchen gekennzeichnet. So ist vorgesehen, den Prüfkontaktstift in einem gesondert dafür gebildeten Kanal im Reihenklemmengehäuse zu führen, was zur hohen mechanischen Stabilität der Verbindung zwischen Prüfstecker und Reihenklemme, auch auf engstem Raum, beiträgt. Dazu trägt auch bei, daß am Steckergehäuse in Parallelanordnung zu dem Betätigungshebel ein Führungsbein angeordnet ist. Bei hoher Sicherheit der Steckverbindung auch bei mechanischen Belastungen kann man die Anordnung insgesamt so klein bauen, daß der Prüfsteckerinsgesamt im Bereich beispielsweise der Zugangsöffnung zu einem Klemmfederanschluß im Reihenklemmengehäuse untergebracht werden kann, eine Zugangsöffnung, die nach Tätigung dieses Anschlusses für eine andere Funktion der Reihenklemmen nicht benötigt wird. Insbesondere wird dank dieser Ausgestaltung nicht der Querverbindungskanal der Reihenklemmen durch die Prüfung mit dem Prüfstecker blockiert. Besonders zweckmäßig ist auch eine Ausgestaltung dahingehend, das Prüfsteckergehäuse und Betätigungshebel seitlich mit Rastelementen zur Blockbildung mit weiteren derartigen Prüfsteckern zu versehen. Es kann auf diese Weise ein Block beispielsweise von zehn Prüfsteckern gebildet werden und durch die seitliche Rastelementenverbindung auch der Betätigungshebel können alle Prüfstecker des Blockes auch gemeinsam im Sinne der Lösung von den Reihenklemmen betätigt werden.

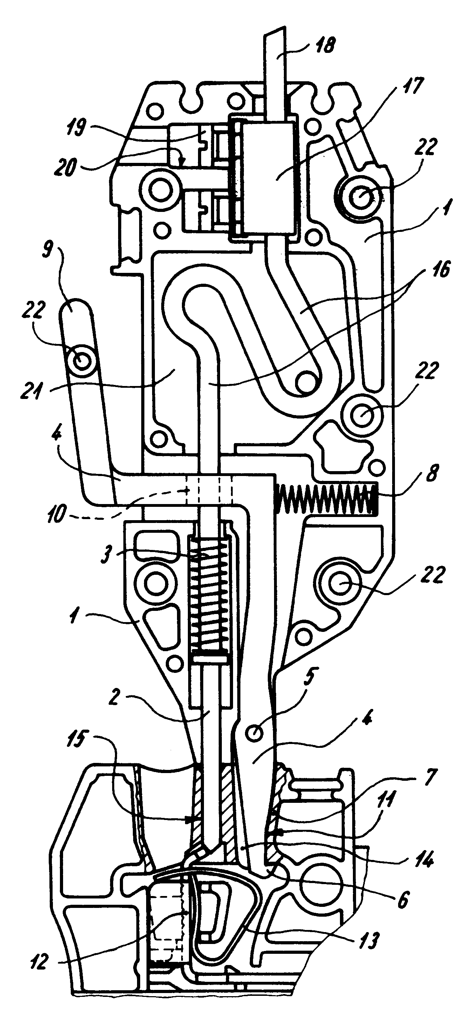

Ein Ausführungsbeispiel eines Prüfsteckers gemäß der Erfindung wird nachstehend unter Bezugnahme auf die beigefügte Zeichnung beschrieben.

Die Zeichnung zeigt einen Prüfstecker gemäß der Erfindung in Seitenansicht bei geöffnetem Gehäuse mit Teilschnittdarstellung einer Reihenklemme, auf die der Prüfstecker aufgesteckt ist.

Der Prüfstecker besitzt ein Gehäuse 1 aus elektrisch isolierendem Kunststoff, in dem in seinem unteren Bereich zur elektrischen Prüfung von Reihenklemmen ein Prüfkontaktstift 2 gegen die Kraft einer Feder 3 verschieblich geführt ist. Zur mechanisch sicheren, auch gegenüber äußeren mechanischen Belastungen stabilen Festsetzung des Prüfsteckers auf der Reihenklemme ist an dem Steckergehäuse 1 ein Bein vorgesehen, das als länglicher Betätigungshebel 4 ausgebildet ist, der im unteren Bereich des Steckergehäuses um eine Drehachse 5 drehbar gelagert ist und an seinem unteren freien Ende einen Rasthaken 6 aufweist, mit dem in der Verrastungslage eine entsprechende angrenzende Kontur des Klemmengehäuses 7 der Reihenklemme untergriffen werden kann. Der Betätigungshebel 4 ist dabei in Verhakungdrehrichtung unter Federkraft gesetzt. Im dargestellten Ausführungsbeispiel ist hierzu oberhalb der Drehachse 5 im Steckergehäuse 1 in einer entsprechenden Ausnehmung eine eigenständige Feder 8 vorgesehen, die den Betätigungshebel 4 im genannten Sinn beaufschlagt. Die Feder 8 liegt dabei quer zur Längserstreckung des Prüfsteckers und damit quer zur hauptsächlich gefährdenten Abzugsrichtung nach. oben. Anstelle der gesonderten Feder 8 könnte auch eine einstückig an den Betätigungshebel angeformte Kunststoffeder vorgesehen sein. Der Betätigungshebel 4 ist im Bereich des Angriffspunktes der Feder 8 nach außen abgewinkelt und endet in einer oberen Handhabe 9. In dem abgewinkelten Bereich ist dabei eine Ausnehmung 10 zum freien Durchtritt des zum Stift 2 führenden Leiters vorgesehen. Aufgrund der geschilderten Anordnung wird der Betätigungshebel 4 in der Ruhelage in unbestimmter Position gehalten. Beim Aufsetzen des Prüfsteckers auf die Reihenklemme wird der Betätigungshebel 4 gegen die Kraft der Feder 8 durch die entsprechende Kontur der Zugangsöffnung 11 im Reihenklemmengehäuse 7 zurückgedrängt und schnappt aufgrund der Wirkung der Feder 8 am Ende der Einsteckbewegung mit dem Rasthaken 6 unter die entsprechende Klemmengehäusekontur, so daß eine sichere formschlüssige mechanische Verbindung gewährleistet ist, die aufgrund der Stabilität des Betätigungshebels auch gegenüber mechanischen Belastungen so stabil ist, daß der Prüfkontaktstift 2 die über seine Spitze erreichte Kontaktierung beispielsweise im dargestellten Ausführungsbeispiel zur abgewinkelten Stromschiene 12 der Reihenklemme nicht verliert. Im dargestellten Ausführungsbeispiel ist eine Reihenklemme vorgesehen, die einen Klemmfederanschluß aufweist. Die geschilderte Anordnung des Prüfsteckers baut trotz außerordentlich zuverlässigen mechanischen Haltes so schmal, daß für die Aufsetzung des Prüfsteckers die Zugangsöffnung 11 genutzt werden kann, die die Zugangsöffnung zur Klemmfeder 13 der Reihenklemme bildet, eine Öffnung, die nach Betätigung des Leiteranschlusses nicht mehr benötigt wird.

Zur weiteren Erhöhung des sicheren mechanischen Haltes auch bei mechanischen äußeren Belastungen ist ferner, in Parallellage zum unteren Bereich des Betätigungshebels 4, an dem Steckergehäuse 1 des Prüfsteckers ein starres, paßgenaues Führungsbein 14 angeformt, das mit der entsprechenden Kontur der Zugangsöffnung 11 im Reihenklemmengehäuse 7 zusammenwirkt. Ferner ist im Bereich der Zugangsöffnung 11 im Klemmengehäuse 7 ein gesonderter Kanal 15 gebildet, in dem die Prüfkontaktspitze 2 zusätzlich und eigenständig geführt ist.

In weiterer besonderer Ausgestaltung ist ferner das obere Ende des Prüfkontaktstiftes 2 im Inneren des Steckergehäuses 1 mit einem internen, flexiblen Leiter 16 elektrisch leitend verbunde, der seinerseits zu einem ortsfest im Steckergehäuse 1 angeordneten Leiteranschluß 17 geführt ist. Der Leiteranschluß 17 weist zweckmäßig eine erste Anschlußstelle auf, in der der flexible Leiter 16 festgelegt ist, sowie eine zweite Anschlußstelle, in der der externe Leiter 18 festgelegt wird. In zweckmäßiger Ausgestaltung ist ausschließlich letztere, als Schraubanschluß 19 ausgebildete Anschlußstelle von außen durch eine Zugangsöffnung 20 im Steckergehäuse 1 für den Anwender zugänglich, so daß eine Fehlbedienung beim Leiteranschluß ausgeschlossen ist. Dank der geschilderten Ausgestaltung sind Leiteranschluß und Prüfanschluß praktisch mechanisch voneinander getrennt. Auch durch einen Zug am externen Leiter kann es somit keine negative Beeinflussung des Prüfkontaktes geben. Ein derartiger Leiterzug gelangt nicht auf den Prüfkontaktstift 2, sondern wird vom Steckergehäuse 1 aufgenommen. Dank der Flexibilität des internen Leiters 16 und einer entsprechend großzügig dimensionierten Kammer 21 im Steckergehäuse 1 kann sich der flexible Leiter 16 den Bewegungen des Prüfkontaktstiftes 2 in der erforderlichen Weise im Prüfsteckergehäuse 1 anpassen.

In weiterer zweckmäßiger Ausgestaltung sind an dem Steckergehäuse 1 des Prüfsteckers sowie an dem Betätigungshebel 4, hier im Bereich der freiliegenden Handhabe 9,seitlich Rastelemente vorgesehen, beispielsweise auf der einen Seite Rastbohrungen 22, während auf der anderen Seite entsprechende Raststifte vorgesehen sind. Auf diese Weise lassen sich zahlreiche derartige Prüfstecker auch parallel nebeneinander liegend zu einem Block verrasten, so daß beispielsweise ein Block aus zehn derartigen Prüfsteckern gleichzeitig zu Prüfzwecken auf zehn in der Anreihung nebeneinander liegende Reihenklemmen gesteckt werden kann. Dank der Verrastung auch der Betätigungshebel 4 der Prüfstecker können die Prüfstecker dann gemeinsam als Block auch nach der Prüfung wieder von den Reihenklemmen gelöst werden.

## Patentansprüche

1. Prüfstecker für Reihenklemmen, mit einem Steckergehäuse (1) mit einem abgefedert vorschieblich darin geführten, mit einem Leiter verbundenen Prüfkontaktstift (2), wobei an dem Steckergehäuse (1) ein in eine Zugangsöffnung (11) des Reihenklemmengehäuses (7) einsteckbares Bein (4) vorgesehen ist, das an seinem unteren Ende einen Rasthaken (6) zum Untergreifen einer Klemmengehäusekontur aufweist, **dadurch gekennzeichnet,** daß das Bein ein drehbar am Steckergehäuse (1) gelagerter Betätigungshebel (4) ist, der in Verhakungsdrehrichtung unter Federkraft (8) gesetzt ist.

2. Prüfstecker nach Anspruch 1, dadurch gekennzeichnet, daß an dem Prüfkontaktstift (2) ein flexibler Leiter (16) befestigt ist, der im Steckergehäuse (1) zu einem ortsfest angebrachten Leiteranschluß (17) zum Anschließen eines externen Leiters (18) geführt ist.

3. Prüfstecker nach Anspruch 1 oder 2, dadurch gekennzeichnet, daß der Prüfkontaktstift (2) in einem gesondert dafür gebildeten Kanal (15) im Reihenklemmengehäuse (7) geführt ist.

4. Prüfstecker nach einem der vorhergehenden Ansprüche, dadurch gekennzeichnet, daß an dem Steckergehäuse (1) in Parallelanordnung zu dem Betätigungshebel (4) ein Führungsbein (14) angeordnet ist.

5. Prüfstecker nach Anspruch 2, dadurch gekennzeichnet, daß in dem Betätigungshebel (4) eine Ausnehmung (10) zum freien Durchtritt des flexiblen internen Leiters (16) vorgesehen ist.

6. Prüfstecker nach Anspruch 2, dadurch gekennzeichnet, daß der Leiteranschluß (17) eine Anschlußstelle für den flexiblen internen Leiter (16) und eine weitere Anschlußstelle (19) für den anzuschließenden externen Leiter (18) aufweist und nur die Anschlußstelle (19) für den externen Leiter (18) von außen durch eine Zugangsöffnung (20) im Steckergehäuse (1) zugänglich ist.

7. Prüfstecker nach Anspruch 2, dadurch gekennzeichnet, daß in dem Steckergehäuse (1) eine Kammer (21) zur Aufnahme des sich mit dem Prüfkontaktstift (2) bewegenden flexiblen Leiters (16) gebildet ist.

8. Prüfstecker nach einem der vorhergehenden Ansprüche, dadurch gekennzeichnet, daß am Steckergehäuse (1) und dem Betätigungshebel (4) seitliche Rastelemente (22) zur Blockbildung mit weiteren gleichen Prüfsteckern vorgesehen sind.

9. Prüfstecker nach einem der vorhergehenden Ansprüche, dadurch gekennzeichnet, daß der Betätigungshebel (4) im Bereich des unteren Endes des Steckerghäuses (1) an diesem um eine Drehachse (5) drehbar gelagert ist, die Feder (8) quergerichtet zur Längserstreckung des Prüfsteckers oberhalb der Drehachse (5) an dem Betätigungshebel (4) angreift und der Betätigungshebel (4) im Bereich des Federangriffes nach außen abgewinkelt ist und in einer außerhalb des Steckergehäuses (1) liegenden Handhabe (9) endet.

## Claims

1. A test plug for terminal blocks, comprising a plug housing (1) with a test contact pin (2) which is guided therein in such a way that it can be advanced in sprung relationship and which is connected to a conductor, wherein provided on the plug housing (1) is a leg (4) which can be inserted into an access opening (11) in the terminal block housing (7) and which at its lower end has a retaining hook (6) for engaging under a terminal block housing contour, characterised in that the leg is an actuating lever (4) which is mounted rotatably to the plug housing (1) and which is under a spring force (8) in the hooking direction of rotation.

2. A test plug according to claim 1 characterised in that fixed to the test contact pin (2) is a flexible conductor (16) which is taken in the plug housing (1) to a stationarily disposed conductor connection (17) for the connection of an external conductor (18).

3. A test plug according to claim 1 or claim 2 characterised in that the test contact pin (2) is guided in a passage (15) provided separately for same in the terminal block housing (7).

4. A test plug according to one of the preceding claims characterised in that a guide leg (14) is arranged on the plug housing (1) in parallel relationship with the actuating lever (4).

5. A test plug according to claim 2 characterised in that provided in the actuating lever (4) is an opening (10) for the flexible internal conductor (16) to pass freely therethrough.

6. A test plug according to claim 2 characterised in that the conductor connection (17) has a connecting terminal for the flexible internal conductor (16) and a further connecting terminal (19) for the external conductor (18) to be connected and only the connecting terminal (19) for the external conductor (18) is accessible from the exterior through an access opening (20) in the plug housing (1).

7. A test plug according to claim 2 characterised in that a chamber (21) is formed in the plug housing (1) for receiving the flexible conductor (16) which moves with the test contact pin (2).

8. A test plug according to one of the preceding claims characterised in that lateral retaining elements (22) are provided on the plug housing (1) and the actuating lever (4) for forming a block with further identical test plugs.

9. A test plug according to one of the preceding claims characterised in that in the region of the lower end of the plug housing (1) the actuating lever (4) is mounted to the plug housing rotatably about an axis of rotation (5), the spring (8) engages the actuating lever (4) in transversely directed relationship with respect to the longitudinal extent of the test plug above the axis of rotation (5) and the actuating lever (4) is angled outwardly in the region of the spring engagement and terminates in a handle (9) which is outside the plug housing (1).

## Revendications

1. Fiche-test pour bornes en ligne, comprenant un boîtier de fiche (1) comportant une tige de contact de test (2) qui y est guidée et poussée élastiquement et qui est reliée à un conducteur, une patte (4) susceptible d'être introduite dans une ouverture d'accès (11) du boîtier de bornes en ligne (7) étant prévue, sur le boîtier de fiche (1), patte qui présente, à son extrémité inférieure, un crochet d'enclenchement (6) destiné à saisir le contour du boîtier de bornes, **caractérisée en ce que** la patte est un lever d'actionnement (4), monté tournant sur le boîtier de la fiche (1), qui, dans la direction de rotation de verrouillage, est soumis à l'action d'une force élastique (8).

2. Fiche-test selon la revendication 1, **caractérisée en ce qu**'est fixé, sur la tige de contact de test (2), un conducteur (16) flexible, qui mène, à l'intérieur du boîtier de fiche (1), à un raccordement de conducteur (17) monté fixe, destiné au raccordement d'un conducteur (18) externe.

3. Fiche-test selon la revendication 1 ou 2, **caractérisée en ce que** la tige de contact de test (2) est montée dans un canal (15), formé spécialement pour elle dans le boîtier de bornes en ligne (7).

4. Fiche-test selon l'une des revendications précédentes, **caractérisée en ce qu**' une patte de guidage (14) est montée, sur le boîtier de fiche (1), parallèlement au levier d'actionnement (4).

5. Fiche-test selon la revendication 2, **caractérisée en ce qu**'est prévu, dans le levier d'actionnement (4), un évidement (10) pouvant être traversé librement par le conducteur interne (16) flexible.

6. Fiche-test selon la revendication 2, **caractérisée en ce que** le raccordement de conducteur (17) présente un point de raccordement destiné au conducteur interne (16) flexible, et un autre point de raccordement (19) destiné au conducteur externe (18), destiné à être raccordé, et **en ce que** seul le point de raccordement (19) destiné au conducteur externe (18) est accessible de l'extérieur, par une ouverture d'accès (20) ménagée dans le boîtier de fiche (1).

7. Fiche-test selon la revendication 2, **caractérisée en ce qu**'est formée, dans le boîtier de fiche (1), une chambre (21) destinée à loger le conducteur (16) flexible qui se déplace avec le tige de contact de test (2).

8. Fiche-test selon lune des revendications précédentes, **caractérisée en ce que** sont prévus, sur le boîtier de fiche (1) et le levier d'actionnement (4), des éléments d'enclenchement (22) latéraux, destinés à former un bloc avec d'autres fiches-test identiques.

9. Fiche-test selon l'une des revendications précédentes, **caractérisée en ce que** le lever d'actionnement (4), dans la zone de l'extrémité inférieure du boîtier de fiche (1), est monté tournant sur celle-ci autour d'un axe de rotation (5), en ce que le ressort (8), orienté perpendiculairement à la direction longitudinale de la fiche-test, s'applique sur le levier d'actionnement (4) au-dessus de l'axe de rotation (5), et en ce que le levier d'actionnement (4), dans la zone d'application du ressort, est coudé vers l'extérieur, et se termine par une manette (9) située à l'extérieur du boîtier de fiche (1).
